# EUROPÄISCHE PATENTSCHRIFT

(11) **EP 4 150 763 B1**
(45) Veröffentlichungstag und Bekanntmachung des Hinweises auf die Patenterteilung: **28.01.2026**
(21) Anmeldenummer: 21724611.5
(22) Anmeldetag: 05.05.2021
(51) Int. Cl.: H03K 17/0812, H03F 3/00, H03F 3/193

(54) **SCHALTUNGSANORDNUNG ZUR BEGRENZUNG DES GATESTROMS AN EINEM FELDEFFEKTTRANSISTOR**
CIRCUIT ASSEMBLY FOR LIMITING THE GATE CURRENT AT A FIELD-EFFECT TRANSISTOR
CIRCUIT POUR LIMITER LE COURANT DE GRILLE AU NIVEAU D'UN TRANSISTOR À EFFET DE CHAMP

(30) Priorität: 13.05.2020 DE 102020112980
(43) Veröffentlichungstag der Anmeldung: 22.03.2023
(73) Patentinhaber: Ferdinand-Braun-Institut gGmbH, Leibniz-Institut für Höchstfrequenztechnik, 12489 Berlin (DE)
(72) Erfinder: KRAUSE, Sascha, 12439 Berlin (DE)
(74) Vertreter: Gulde & Partner
(86) Internationale Anmeldenummer: PCT/EP2021/061843
(87) Internationale Veröffentlichungsnummer: WO 2021/228652

(56) Entgegenhaltungen:
- WO-A1-2006/036060
- WO-A1-2017/027346
- US-A1- 2016 380 600
- DELIAS A ET AL: "A GaN-based supply modulator for energy efficiency enhancement of active phased-array antennas", 2014 INTERNATIONAL WORKSHOP ON INTEGRATED NONLINEAR MICROWAVE AND MILLIMETRE-WAVE CIRCUITS (INMMIC), IEEE, 2 April 2014 (2014-04-02), pages 1 - 3, XP032595479, [retrieved on 20140513], DOI: 10.1109/INMMIC.2014.6815105

## Beschreibung

### Beschreibung

Die vorliegende Erfindung betrifft eine Verstärkerschaltung mit einer Schaltungsanordnung zur Begrenzung des Gatestroms an einem Feldeffekttransistor, insbesondere eine analoge Verstärkerschaltung mit einer Schaltungsanordnung zur Begrenzung des Gatestroms an einem GaN oder GaAs HF Leistungs-HEMT.

### Stand der Technik

Die Entwicklung von Elektronik, die sowohl höhere Frequenzen und Leistungen bei kleineren Dimensionen liefern kann, stellt vor allem im Mikrowellenbereich aufgrund der geltenden physikalischen Gesetzmäßigkeiten eine Herausforderung dar. Dabei ermöglichen höhere Sendefrequenzen in der Nachrichten- und Kommunikationstechnik höhere Bandbreiten und schnellere Datenübertragung (z. B. 5G) sowie eine zeitlich- und räumlich feinere Auflösung für Radarapplikationen sowohl in zivilen wie auch in militärischen Einsatzgebieten. Einen maßgeblichen Beitrag zum heutigen Stand der Technik ist dem High Electron Mobility Transistor (HEMT) geschuldet, welcher auch als Heterojunction Field-Effect Transistor (HFET), Two-Dimensional Electron-Gas Field-Effect Transistor (TEGFET), Modulation-Doped Field-Effect Transistor (MODFET) oder abkürzend auch einfach als Feldeffekttransistor (FET) bezeichnet wird. Dabei nutzt dieser spezielle Feldeffekttransistor zwei heterogene Halbleitermaterialen mit unterschiedlichen Bandlücken um an der Grenzschicht einen quasi zweidimensionalen Kanal gefüllt mit Elektronen bereitzustellen. In diesem undotierten, auch 2-DEG ("two dimensional electron-gas") genannten Bereich können hohe Elektronenmobilitäten erreicht werden, welches die hohen erreichbaren Betriebsfrequenzen dieser Technologie ermöglicht.

Der am weiten verbreitetste HEMT basiert auf der Gallium-Arsenid (GaAs) Technologie, welche allerdings in vielen Bereichen von der heranreifenden Gallium-Nitrid (GaN) Technik ersetzt wird. Aufgrund der höheren Bandlücke und Stromtragfähigkeit in GaN können erheblich größere Leistungen erzielt werden, ohne dabei in anderen elektrischen Parametern wie der Rauschzahl nennenswerte Nachteile aufzuweisen. Dies ermöglicht Transceiver bestehend aus einem leistungs- und rauscharmen Verstärker ("low noise amplifier", LNA) auf einen einzigen Chip monolithisch zu integrieren, spart damit Kosten und reduziert die Komplexität und die Abmessungen der Komponente.

Im Allgemeinen ist ein rauscharmer Verstärker darauf optimiert, schwache HF-Signale (Signale im Hochfrequenzbereich (HF) von 9 kHz bis etwa 30 GHz) möglichst rauscharm zu verstärken, allerdings können auch hier durchaus große Leistungen am Eingang auch bei Frequenzen außerhalb der eigentlichen Empfangsfrequenz auftreten, z. B. durch ungewollte Kopplungen, Reflektionen des Leistungsverstärkers oder starke Störsignale (Jammer). Diese können die Funktionstüchtigkeit des Empfängers temporär oder permanent negativ beeinflussen.

Um das empfindliche und wichtige Bauteil zu schützen, kommen bei herkömmlichen GaAs LNA Limiterdioden (Dioden, Zehnerdioden) als Begrenzungsschalter am Eingang zum Einsatz, diese können allerdings nicht monolithisch integriert werden und erfordern einen zweiten Chip. GaN HEMT hingegen sind nicht zwingend auf externe Begrenzungsbeschaltungen angewiesen, da sie durch die hohe Durchbruchsspannung weitaus höhere Leistungen tolerieren können. Diese liegen üblicherweise im Bereich von 10 W. Allerdings können auch Werte bis 30 W erreicht werden, falls ein hochohmiger Widerstand am Gate verwendet wird (M. Rudolph et al., "Robust Stacked GaN-Based Low-Noise Amplifier MMIC for Receiver Applications", IEEE Trans. Microwave Theory Tech., Bd. 1, Nr. 55, pp. 37-43, Jan 2007). Im Überlastfall wird der Gatestrom durch diesen Serienwiderstand begrenzt, der auftretende Spannungsabfall über diesem bewirkt dabei jedoch eine Verschiebung des Arbeitspunktes des Transistors in einen tiefen Klasse C Betrieb bei gleichzeitig steigenden negativen Gatespannungen.

Bei hohen Eingangsleistungen sind die Spannungsamplituden am Eingang des Transistors allerdings so groß, dass sich ein Durchflussstrom am Gate einstellt. Dieser Gatestrom wirkt sich besonders schädlich auf die Robustheit bzw. die Lebensdauer des Transistors aus (M. Broasa et al. "Correlation of gate leakage and strain distribution in GaN/AIGaN HEMT structures", in 27th European Symposium on Reliability of Electron Devices, failure physics and analysis (ESREF), Halle (Saale), Germany, 2016). Der Durchflussstrom wird üblicherweise durch den besagten hochohmigen Widerstand im Gate-Versorgungsnetzwerk verringert.

Die durch den fließenden Strom über den Widerstand abfallende Spannung ist dabei so gepolt, dass sich am Gate negativere Spannungen einstellen, die wiederum den Transistor weiter in den Pinch-off treiben und ihn dadurch auf Kosten von erhöhten negativen Sperrspannungen vor hohen Gateströmen schützen (GB 2 165 114 A). Allerdings ist es mit dieser Methode nicht möglich den Gatestrom vollständig abzuregeln, sondern lediglich zu reduzieren. Mit steigenden Eingangsleistungen erhöht sich somit auch weiterhin der Durchlassstrom am Gate.

Die WO 2006/036060 A1 betrifft eine Verstärkerschaltung und eine Schaltung zur Bereitstellung einer Bias-Spannung am Gate-Anschluss eines Feldeffekttransistors (FET). Die WO 2017/027346 A1 bezieht sich allgemein auf Kaskadenverstärker auf Kaskadenverstärker und insbesondere auf DC-Vorspannungsregler für Kaskadenverstärker. Die US 2016/0380600 A1 betrifft Hochleistungs-Hochfrequenz-Leistungsverstärker. Aus der Veröffentlichung Délias et al. ("A GaN-based supply modulator for energy efficiency enhancement of active phased-array antennas." 2014 International Workshop on Integrated Nonlinear Microwave and Millimetre-wave Circuits (INMMiC). IEEE, 2014) ist ein dynamischer Versorgungsmodulator, der sich für die Umwandlung von Gleichstrom in Hochfrequenzleistung in HF-Sendern eignet und an den Drain-Bias-Anschuss eines 8-W-S-Band-HF-Leistungsverstärkers angeschlossen ist, bekannt.

### Offenbarung der Erfindung

Es ist daher eine Aufgabe der vorliegenden Erfindung, eine Verstärkerschaltung mit einer Schaltungsanordnung zur Begrenzung des Gatestroms an einem Feldeffekttransistor zur Verfügung zu stellen, mit dessen Hilfe der Durchlassstrom im eingangsseitigen Überlastfall effektiv begrenzt wird. Insbesondere soll auch bei sehr hohen Eingangsleistungen der Durchlassstrom am Gate begrenzt werden und sich nicht weiter erhöhen.

Diese Aufgaben werden erfindungsgemäß durch die Merkmale des Patentanspruches 1 gelöst. Zweckmäßige Ausgestaltungen der Erfindung sind in den jeweiligen Unteransprüchen enthalten. Des Weiteren wird darauf basierend ein Gerät zum Empfang von Mikrowellensignalen vorgeschlagen.

Eine erfindungsgemäße Verstärkerschaltung mit einer Schaltungsanordnung zur Begrenzung des Gatestroms an einem Feldeffekttransistor, FET, im eingangsseitigen Überlastfall umfasst einen ersten FET und ein mit einem Gate-Anschluss des ersten FET verbundenes Gleichspannungs-Versorgungsnetzwerk; wobei das Versorgungsnetzwerk über eine erste Verbindung, welche einen hochohmigen Widerstand R₁ und einen dazu in Reihe geschalteten zweiten FET mit einem Gate-Anschluss umfasst, eine Spannung V_{gg} (Gatespannung, auch als Gate-AN-Spannung, Hilfsspannung oder Gate-Bias-Spannung bezeichnet) am Gate-Anschluss des ersten FET bereitstellt; wobei der zweite FET einen AN-Zustand bei einer Gate-Source-Spannung von 0 V aufweist und dessen Gate-Anschluss über eine zweite Verbindung ebenfalls mit dem Gate-Anschluss des ersten FET verbunden ist; wobei die zweite Verbindung einen Strompfad parallel zum Widerstand R₁ bereitstellt; wobei ein am Widerstand R₁ auftretender Spannungsabfall zu einer zunehmenden Sperrung des zweiten FET führt, wobei eine zu verstärkende Eingangsleistung Pᵢₙ über eine mit dem Gate-Anschluss des ersten FET verbundene dritte Verbindung in den ersten FET eingespeist wird. Hierbei kann es sich insbesondere um eine analoge LNA-Verstärkerschaltung handeln.

Als hochohmig werden dabei insbesondere Widerstände mit mehreren tausend Ohm angesehen. Vorzugsweise hat der Widerstand R₁ zwischen 1 kΩ und 10 MΩ, bevorzugter zwischen 1 kΩ und 1 MΩ, bevorzugter zwischen 1 kΩ und 100 kΩ, bevorzugter zwischen 1 kΩ und 10 kΩ, und noch bevorzugter zwischen 5 kΩ und 10 kΩ. Kleinere hochohmige Widerstände im Versorgungsnetzwerk ermöglichen dabei geringere Entlade- bzw. Aufladezeiten (Zeitkonstanten) und tragen somit zu einer schnelleren Erholung des ersten Transistors nach einem Überlastszenario bei (der ursprüngliche Bias des Versorgungspunktes wird schneller wiederhergestellt). Für die vorgeschlagene Beschaltung ist im Prinzip jede Art von Feldeffekttransistor mit einem AN-Zustand bei einer Gate-Source-Spannung von 0 V geeignet. Vorzugsweise sind die erste Verbindung und die zweite Verbindung ohne weitere Schaltelemente mit dem Gate-Anschluss des ersten FET verbunden. Abschnittsweise können die erste Verbindung und die zweite Verbindung auch als gemeinsame Verbindung ausgeführt sein. Unter einer Verbindung wird dabei insbesondere eine elektrische Leiterbahn bzw. allgemein ein elektrischer Leiter bzw. eine Leitung zur Verbindung von elektronischen Bauelementen verstanden. Vorzugsweise umfasst die Verbindung des Versorgungsnetzwerks an den Gate-Anschluss des ersten FET keine weiteren als die in dieser Anmeldung als erfindungsgemäß benannten Elemente. Bevorzugt basiert der erste FET auf GaN-Technologie, welche aufgrund der höheren Bandlücke und einer damit einhergehenden hohen Sperrspannung sowie der höheren Stromtragfähigkeit erheblich größere Leistungen erzielen kann, ohne dabei in anderen elektrischen Parametern wie der Rauschzahl nennenswerte Nachteile aufzuweisen. Besonders bevorzugt handelt es sich bei dem FET um einen HEMT. Eine erfindungsgemäße Schaltungsanordnung ist insbesondere zum Aufbau einer analogen LNA-Verstärkerschaltung mit hohen Eingangsleistungen geeignet.

Die Erfindung beschreibt somit eine Modifikation im Gleichspannungs-Versorgungsnetzwerk eines FET mit dessen Hilfe der Durchlassstrom im eingangsseitigen Überlastfall durch eine stromabhängige adaptive Widerstandsregelung effektiv begrenzt wird. Die Begrenzungsschaltung besteht dabei im Wesentlichen aus dem zweiten FET (normal-AN, Verarmungstyp) und dem ersten Widerstand R₁. Der Wert des Widerstandes R₁ bestimmt dabei zusammen mit der Schwellspannung des zweiten FET die Effektivität der Schaltung. Ein höherer Widerstand führt zu einer stärkeren Überstromunterdrückung, wobei allerdings die Zeitkonstante des Versorgungsnetzwerkes herabgesetzt wird.

Es handelt sich hierbei um eine einfache Feedbackschleife. Dabei wird der vorhandene Gatewiderstand jedoch nicht wie üblich als Strombegrenzung genutzt, sondern über die abfallende Spannung bei fließendem Gatestrom wird eine Steuerspannung erzeugt, welche wiederum den in Serie liegenden zweiten FET (Verarmungsmode, normal-AN) zunehmend sperrt. Dies lässt sich mit einem variablen Widerstand im Versorgungsnetzwerk vergleichen, dessen Wert sich mit steigendem Gatestrom stetig erhöht und dadurch eine effektive Begrenzung des Stromes darstellt, der dann weitestgehend unabhängig von der am ersten FET anliegenden HF-Eingangsleistung ist.

Diese Anordnung wirkt sich im Vergleich weder negativ auf das Kleinsignalverhalten, die Rauschzahl eines damit aufgebauten Verstärkers noch auf die auftretenden Sperrspannungen auf. Simulationen veranschaulichen, dass bei gleichbleibenden Widerstandswerten eine ca. 20-fache Stromreduktion für hohe Eingangsleistungen (44 dBm) möglich ist und der Strom effektiv begrenzt wird, wobei dessen Höhe sich aus dem gewählten Widerstandswert des ersten Widerstands R₁ und der Schwellenspannung des zweiten FET bestimmt. Bei einem gleichbleibenden Schutzverhalten ist es zudem möglich, einen geringeren Widerstand zu wählen, wodurch sich die Zeitkonstante des Versorgungsnetzwerkes verringert und dadurch auch kürzere Erholungszeiten eines LNA nach einem Überlastszenario erzielt werden können.

Ein weiterer Vorteil gegenüber Begrenzungsschaltungen für den Gatestrom auf der Basis von Dioden besteht für analoge Verstärker darin, dass der höchste tolerierbare Gatestrom frei gewählt werden kann und sich aus dem Widerstandswert des ersten Widerstands R₁ sowie der Pinch-Off Spannung des zweiten FET bestimmt. Eine erfindungsgemäße Schaltungsanordnung ist weitestgehend unabhängig von der Bauform des verwendeten zweiten FET. Dieser muss lediglich in der Lage sein, Sperrspannungen zwischen Drain und Source zu tolerieren, welche auch mit der konventionellen Methode am Widerstand im Versorgungsnetzwerk anfallen.

Vorzugsweise ist zur HF-Entkopplung in der zweiten Verbindung ein zweiter hochohmiger Widerstand R₂ angeordnet. Vorzugsweise hat der Widerstand R₂ zwischen 1 kΩ und 10 MΩ, bevorzugter zwischen 1 kΩ und 1 MΩ, bevorzugter zwischen 1 kΩ und 100 kΩ, und noch bevorzugter zwischen 1 kΩ und 10 kΩ.

Vorzugsweise sind zur HF-Entkopplung die erste Verbindung und die zweite Verbindung über eine gemeinsame Induktivität L (als Drossel) mit dem Gate-Anschluss des ersten FET verbunden. Eine Verbindung über eine gemeinsame Induktivität bedeutet dabei, dass zumindest in einem Abschnitt die erste Verbindung und die zweite Verbindung auch als gemeinsame Verbindung ausgeführt sind, wobei dieser Abschnitt eine Induktivität L aufweist bzw. ein induktives Element mit einem Induktivitätswert L umfasst. Die Induktivität L wird dabei als Element des Versorgungsnetzwerks aufgefasst. Deren Größe richtet sich in einer Verstärkerschaltung beispielsweise nach der Betriebsfrequenz des Verstärkers. Bevorzugt hat die Induktivität L zwischen 1 nH und 10 mH, bevorzugter zwischen 10 nH und 1 mH und noch bevorzugter zwischen 10 nH und 100 µH.

Vorzugsweise ist der erste FET ein GaN oder GaAs HF Leistungs-HEMT. Die GaN HEMT Technologie zeichnet sich aufgrund der großen Bandlücke und der damit hohen Durchbruchsspannung als robuste Technologie für den HF-Leistungsbereich aus, allerdings haben sich vor allem Durchflussströme, die sich bei hohen Eingangsleistungen einstellen als besonders schädlich für deren Lebensdauer erwiesen. Eine erfindungsgemäße Schaltungsanordnung ist hingegen in der Lage, diesen Strom effektiv zu begrenzen. Zudem wird das Kleinsignal- und Rauschverhalten nicht beeinflusst, so dass insbesondere besonders robuste und störunempfindliche LNA für den Hochleistungsbereich damit realisiert werden können. Ein auf GaAs HEMT Technologie basierender erster FET kann mit leichten Einschränkungen jedoch ebenfalls in einer erfindungsgemäßen Schaltungsanordnung verwendet werden.

Vorzugsweise sind der erste FET und der zweite FET monolithisch auf einem Chip integriert. Dadurch lassen sich besonders kompakte und robuste LNA realisieren sowie deren Frequenzbandbreite erhöhen. Weiterhin können dadurch die Herstellung von LNA vereinfacht und deren Aufbaukosten reduziert werden.

Alternativ können der erste FET und der zweite FET jedoch auch auf verschiedenen Chips angeordnet sein. Obwohl dieses im Allgemeinen höhere Aufbaukosten und Verluste bedeutet, kann durch solch einen hybriden Ansatz eine größere Flexibilität in der Abstimmung der einzelnen Schaltungselemente erreicht werden.

Vorzugsweise umfasst die Schaltungsanordnung keine Dioden oder Zehnerdioden zur Begrenzung des Gatestroms am ersten FET. Diese kommen üblicherweise bei LNA als Limiterdioden am Eingang zum Einsatz, um das empfindliche und wichtige Bauteil zu schützen. Diese können allerdings nicht monolithisch integriert werden und erfordern einen zweiten Chip.

Ein weiterer Aspekt der Erfindung betrifft ein Gerät zum Empfang von Mikrowellensignalen, welches eine erfindungsgemäße Verstärkerschaltung umfasst. Bei diesen Mikrowellensignalen kann es sich insbesondere um Signale zur Datenübertragung (z. B. 5G) oder für Radarapplikationen sowohl in zivilen wie auch in militärischen Einsatzgebieten handeln.

Weitere bevorzugte Ausgestaltungen der Erfindung ergeben sich aus den in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

### Kurzbeschreibung der Zeichnungen

Die Erfindung wird nachfolgend in Ausführungsbeispielen anhand der zugehörigen Zeichnung erläutert. Es zeigen:
- Fig. 1: eine schematische Darstellung einer herkömmlichen Verstärkerschaltung mit einer Schaltungsanordnung zur Begrenzung des Gatestroms in einer Verstärkerschaltung,
- Fig. 2: eine schematische Darstellung einer ersten Ausführungsform einer erfindungsgemäßen Verstärkerschaltung mit einer Schaltungsanordnung zur Begrenzung des Gatestroms in einer Verstärkerschaltung,
- Fig. 3: eine schematische Darstellung einer zweiten Ausführungsform einer erfindungsgemäßen Verstärkerschaltung mit einer Schaltungsanordnung zur Begrenzung des Gatestroms in einer Verstärkerschaltung,
- Fig. 4: eine schematische Darstellung einer dritten Ausführungsform einer erfindungsgemäßen Verstärkerschaltung mit einer Schaltungsanordnung zur Begrenzung des Gatestroms in einer Verstärkerschaltung, und
- Fig. 5: verschiedene Kennkurven zum Vergleich einer herkömmlichen Strombegrenzerschaltung und eine erfindungsgemäßen Strombegrenzerschaltung.

### Ausführliche Beschreibung der Zeichnungen

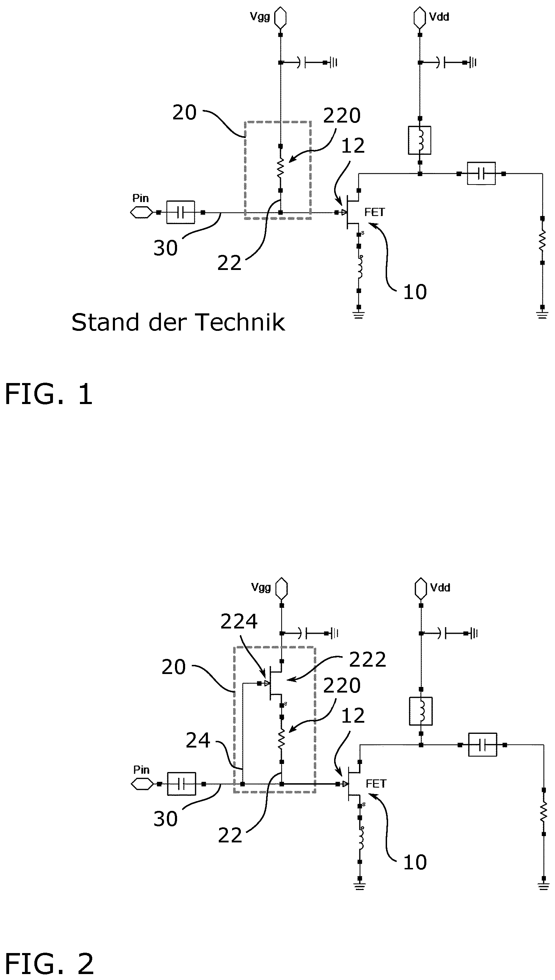

Fig. 1 zeigt eine schematische Darstellung einer herkömmlichen Verstärkerschaltung mit einer Schaltungsanordnung zur Begrenzung des Gatestroms in einer Verstärkerschaltung. Diese umfasst einen in seinem Gatestrom zu begrenzenden FET 10 und ein mit einem Gate-Anschluss 12 des FET 10 verbundenes Gleichspannungs-Versorgungsnetzwerk 20; wobei das Versorgungsnetzwerk 20 über eine Verbindung 22, welche einen hochohmigen Widerstand R 220 umfasst, eine Spannung V_{gg} am Gate-Anschluss 12 des FET 10 bereitstellt; wobei ein am Widerstand R 220 auftretender Spannungsabfall zu einer zunehmenden Reduzierung des Gatestroms am FET 10 führt. Bei der beispielhaft gezeigten Verstärkerschaltung wird eine zu verstärkende Eingangsleistung Pᵢₙ über eine dritte Verbindung 30, welche mit dem Gate-Anschluss 12 des ersten FET 10 verbunden ist, in den ersten FET 10 eingespeist.

Bei hohen Eingangsleistungen Pᵢₙ sind die Spannungsamplituden am Eingang des FET 10 allerdings so groß, dass sich ein Durchflussstrom am Gate-Anschluss 12 einstellt. Dieser wirkt sich besonders schädlich auf die Robustheit bzw. Lebensdauer des FET 10 aus und wird durch den hochohmigen Widerstand R 220 im Versorgungsnetzwerk 20 verringert. Die durch den fließenden Strom über den Widerstand R 220 abfallende Spannung ist dabei so gepolt, dass sich am Gate-Anschluss 12 negativere Spannungen einstellen, die wiederum den FET 10 weiter in den Pinch-off treiben und ihn dadurch auf Kosten von erhöhten negativen Sperrspannungen vor hohen Gateströmen schützen. Allerdings ist es mit dieser Methode nicht möglich den Gatestrom abzuregeln, sondern lediglich zu reduzieren. Mit steigenden Eingangsleistungen Pᵢₙ erhöht sich somit auch weiterhin der Durchlassstrom am Gate-Anschluss 12.

Fig. 2 zeigt eine schematische Darstellung einer ersten Ausführungsform einer erfindungsgemäßen Verstärkerschaltung mit einer Schaltungsanordnung zur Begrenzung des Gatestroms in einer Verstärkerschaltung. Diese umfasst einen in seinem Gatestrom zu begrenzenden ersten FET 10 und ein mit einem Gate-Anschluss 12 des ersten FET 10 verbundenes Gleichspannungs-Versorgungsnetzwerk 20; wobei das Versorgungsnetzwerk 20 über eine erste Verbindung 22, welche einen hochohmigen Widerstand R₁ 220 und einen dazu in Reihe geschalteten zweiten FET 222 mit einem Gate-Anschluss 224 umfasst, eine Spannung V_{gg} am Gate-Anschluss 12 des ersten FET 10 bereitstellt; wobei der zweite FET 222 einen AN-Zustand bei einer Gate-Source-Spannung von 0 V aufweist und dessen Gate-Anschluss 224 über eine zweite Verbindung 24 parallel zum Widerstand R₁ 220 ebenfalls mit dem Gate-Anschluss 12 des ersten FET 10 verbunden ist; wobei ein am Widerstand R₁ 220 auftretender Spannungsabfall zu einer zunehmenden Sperrung des zweiten FET 222 führt. Bei der beispielhaft gezeigten erfindungsgemäßen Verstärkerschaltung wird eine zu verstärkende Eingangsleistung Pᵢₙ über eine dritte Verbindung 30, welche mit dem Gate-Anschluss 12 des ersten FET 10 verbunden ist, in den ersten FET 10 eingespeist.

Über die am ersten Widerstand R₁ 220 abfallende Spannung bei fließendem Gatestrom wird eine Steuerspannung erzeugt, welche den in Serie liegenden FET (Verarmungsmode, normal-AN) zunehmend sperrt. Dies lässt sich mit einem variablen Widerstand im Versorgungsnetzwerk vergleichen, dessen Wert sich mit steigendem Gatestrom stetig erhöht und dadurch eine effektive Begrenzung des Stromes darstellt, der weitestgehend unabhängig von der anliegenden Eingangsleistung Pᵢₙ ist. Bei dem ersten FET 10 kann es sich insbesondere um einen GaN HF Leistungs-HEMT handeln, wobei der erste FET 10 und der zweite FET 222 monolithisch auf einem Chip integriert sein können.

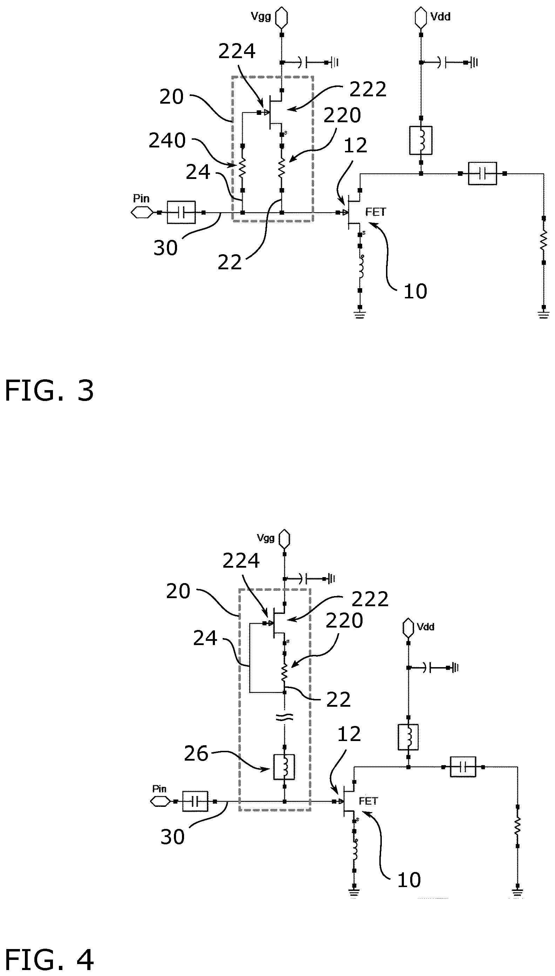

Fig. 3 zeigt eine schematische Darstellung einer zweiten Ausführungsform einer erfindungsgemäßen Verstärkerschaltung mit einer Schaltungsanordnung zur Begrenzung des Gatestroms. Der grundlegende Schaltungsaufbau entspricht der in Fig. 2 gezeigten Ausführungsform. Daher gelten die Bezugszeichen und deren jeweilige Zuordnung zu den einzelnen Merkmalen entsprechend. Zur HF-Entkopplung ist jedoch in der zweiten Verbindung 24 ein zweiter hochohmiger Widerstand R₂ 240 mit dem hochohmigen Widerstand R₁ 220 parallel geschaltet ist. Eine HF-Entkopplung bei der Begrenzung des Gatestroms erfolgt somit erfindungsgemäß über zwei hochohmige Widerstände R₁ 220 und R₂ 240, wobei am in Serie zum zweiten FET 222 liegenden Widerstand R₁ 220 eine Spannung abfällt, welche den zweiten FET 222 zunehmend sperrt und dadurch den Gatestrom des ersten FET 10 begrenzt.

Fig. 4 zeigt eine schematische Darstellung einer dritten Ausführungsform einer erfindungsgemäßen Verstärkerschaltung mit einer Schaltungsanordnung zur Begrenzung des Gatestroms. Der grundlegende Schaltungsaufbau entspricht der in Fig. 2 gezeigten Ausführungsform. Daher gelten die Bezugszeichen und deren jeweilige Zuordnung zu den einzelnen Merkmalen entsprechend. Zur HF-Entkopplung sind jedoch die erste Verbindung 22 und die zweite Verbindung 24 über eine gemeinsame Induktivität L 26 mit dem Gate-Anschluss des ersten FET 10 verbunden. Eine HF-Entkopplung bei der Begrenzung des Gatestroms erfolgt somit erfindungsgemäß über eine mit dem Gate-Anschluss 12 des ersten FET 10 verbundene Induktivität L. Der Widerstand R₁ dient hierbei lediglich zur Erzeugung einer negativen Sperrspannung am Gate-Source des im Versorgungsnetzwerk 20 liegenden zweiten FET 222.

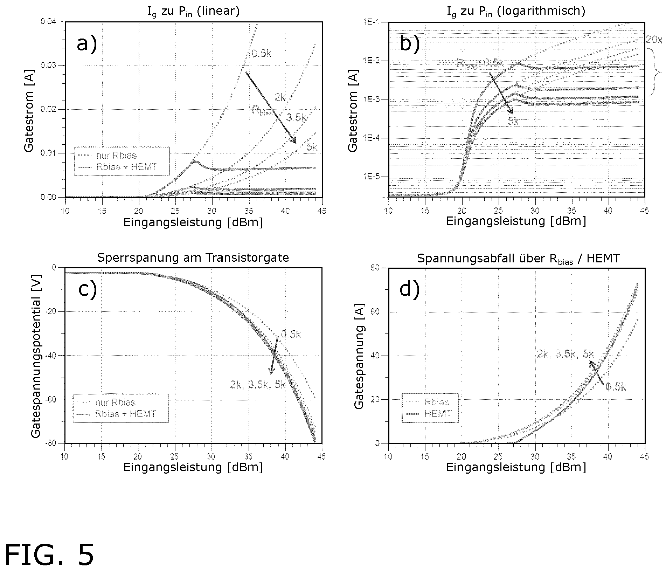

Fig. 5 zeigt verschiedene Kennkurven zum Vergleich einer herkömmlichen Strombegrenzerschaltung und eine erfindungsgemäßen Strombegrenzerschaltung.

Dabei zeigt die Figur a) einen linear und die Figur b) einen logarithmisch skalierten Vergleich zwischen dem auftretenden Gatestrom (in Ampere (A)) bei einer herkömmlichen Widerstandsbeschaltung zur Begrenzung des Gatestroms nach Fig. 1 (unterbrochener Kurvenverlauf) und einer erfindungsgemäßen Schaltungsanordnung nach Fig. 3 (durchgehender Kurvenverlauf), jeweils in Abhängigkeit von der Eingangsleistung Pᵢₙ (in Dezibel Milliwatt (dBm)). Es ist deutlich zu erkennen, dass bei der erfindungsgemäßen Ausführungsform eine weitgehende Abregelung des Gatestroms ermöglicht wird, wobei der maximal zulässige Gatestrom durch Anpassung des ersten Widerstands R₁ ausgewählt werden kann.

Die Figuren c) und d) zeigen jeweils die Sperrspannung am Gate des ersten FET und den Spanungsabfall über dem ersten Widerstand R₁ bei einer herkömmlichen Widerstandsbeschaltung zur Begrenzung des Gatestroms nach Fig. 1 (unterbrochener Kurvenverlauf) und einer erfindungsgemäßen Schaltungsanordnung nach Fig. 3 (durchgehender Kurvenverlauf), jeweils in Abhängigkeit von der Eingangsleistung Pᵢₙ (in Dezibel Milliwatt (dBm)). Die abfallende Spannung am ersten Widerstand R₁ in der konventionellen Beschaltung unterscheidet sich nicht von der auftretenden Spannung über dem ersten FET (V_{ds}) und stellt speziell für die GaN Technologie somit keinerlei Herausforderung dar.

### Bezugszeichenliste

- 10: erster FET
- 12: Gate-Anschluss (erster FET)

- 20: Versorgungsnetzwerk
- 22: erste Verbindung
- 220: hochohmiger Widerstand R₁
- 222: zweiter FET
- 224: Gate-Anschluss (zweiter FET)
- 24: zweite Verbindung
- 240: zweiter hochohmiger Widerstand R₂
- 26: Induktivität L
- 30: dritte Verbindung

## Patentansprüche

1. Verstärkerschaltung mit einer Schaltungsanordnung zur Begrenzung des Gatestroms an einem ersten Feldeffekttransistor, FET, (10) im eingangsseitigen Überlastfall, die Schaltungsanordnung umfassend den ersten FET (10) und ein mit einem Gate-Anschluss (12) des ersten FET (10) verbundenes Gleichspannungs-Versorgungsnetzwerk (20); wobei das Versorgungsnetzwerk (20) über eine erste Verbindung (22), welche einen hochohmigen Widerstand R₁ (220) und einen dazu in Reihe geschalteten zweiten FET (222) mit einem Gate-Anschluss (224) umfasst, eine Spannung V_{gg} am Gate-Anschluss (12) des ersten FET (10) bereitstellt; wobei der zweite FET (222) einen AN-Zustand bei einer Gate-Source-Spannung von 0 V aufweist und dessen Gate-Anschluss (224) über eine zweite Verbindung (24) ebenfalls mit dem Gate-Anschluss (12) des ersten FET (10) verbunden ist; wobei die zweite Verbindung (24) einen Strompfad parallel zum Widerstand R₁ (220) bereitstellt; wobei ein am Widerstand R₁ (220) auftretender Spannungsabfall zu einer zunehmenden Sperrung des zweiten FET (222) führt, wobei eine zu verstärkende Eingangsleistung Pᵢₙ über eine mit dem Gate-Anschluss (12) des ersten FET (10) verbundene dritte Verbindung (30) in den ersten FET (10) eingespeist wird.

2. Verstärkerschaltung nach Anspruch 1, wobei zur HF-Entkopplung in der zweiten Verbindung (24) ein zweiter hochohmiger Widerstand R₂ (240) angeordnet ist.

3. Verstärkerschaltung nach Anspruch 1 oder 2, wobei zur HF-Entkopplung die erste Verbindung (22) und die zweite Verbindung (24) über eine gemeinsame Induktivität L (26) mit dem Gate-Anschluss des ersten FET (10) verbunden sind.

4. Verstärkerschaltung nach einem der vorhergehenden Ansprüche, wobei der erste FET (10) ein GaN oder GaAs HF Leistungs-HEMT ist.

5. Verstärkerschaltung nach einem der vorhergehenden Ansprüche, wobei der erste FET (10) und der zweite FET (222) monolithisch auf einem Chip integriert sind.

6. Verstärkerschaltung nach einem der Ansprüche 1 bis 4, wobei der erste FET (10) und der zweite FET (222) auf verschiedenen Chips angeordnet sind.

7. Verstärkerschaltung nach einem der vorhergehenden Ansprüche, wobei das Versorgungsnetzwerk (20) keine Dioden oder Zehnerdioden zur Begrenzung des Gatestroms am ersten FET (10) umfasst.

8. Gerät zum Empfang von Mikrowellensignalen, eine Verstärkerschaltung nach einem der vorhergehenden Ansprüche umfassend.

## Claims

1. An amplifier circuit with a circuit arrangement for limiting a gate current at a first field-effect transistor (FET) (10) in case of an input-side overload, the circuit arrangement comprising the first FET (10) and a DC voltage supply network (20) connected to a gate terminal (12) of the first FET (10); wherein the supply network (20) provides a voltage V_{gg} at the gate terminal (12) of the first FET (10) via a first connection (22), which comprises a high-resistance resistor R₁ (220) and a second FET (222) connected in series with a gate terminal (224); wherein the second FET (222) has an ON state at a gate-source voltage of 0 V and the gate terminal (224) thereof is also connected to the gate terminal (12) of the first FET (10) via a second connection (24); wherein the second connection (24) provides a current path in parallel to the resistor R₁ (220); wherein a voltage drop occurring across the resistor R₁ (220) leads to an increasing blocking of the second FET (222), wherein a to-be-amplified input power Pᵢₙ is fed into the first FET (10) via a third connection (30) connected to the gate terminal (12) of the first FET (10).

2. The amplifier circuit according to claim 1, wherein a second high-impedance resistor R₂ (240) is arranged in the second connection (24) for RF decoupling.

3. The amplifier circuit according to claim 1 or 2, wherein for the RF decoupling, the first connection (22) and the second connection (24) are connected to the gate terminal of the first FET (10) via a common inductance L (26).

4. The amplifier circuit according to any one of the preceding claims, wherein the first FET (10) is a GaN or GaAs RF power HEMT.

5. The amplifier circuit according to any one of the preceding claims, wherein the first FET (10) and the second FET (222) are monolithically integrated on a single chip.

6. The amplifier circuit according to any one of claims 1-4, wherein the first FET (10) and the second FET (222) are arranged on different chips.

7. The amplifier circuit according to any one of the preceding claims, wherein the power supply network (20) does not comprise any diodes or Zener diodes for limiting the gate current at the first FET (10).

8. A device for receiving microwave signals, comprising the amplifier circuit of any one of the preceding claims.

## Revendications

1. Circuit amplificateur comportant un agencement de circuit destiné à limiter le courant de grille d'un premier transistor à effet de champ, FET, (10) en cas de surcharge côté entrée, l'agencement de circuit comprenant le premier FET (10) et un réseau d'alimentation (20) en tension continue relié à une borne de grille (12) du premier FET (10) ; le réseau d'alimentation (20) fournissant, via une première connexion (22), qui comprend une résistance de haute impédance R₁ (220) et un second FET (222) connecté en série avec celle-ci et comportant une borne de grille (224), une tension V_{gg} à la borne de grille (12) du premier FET (10) ; le second FET (222) présentant un état passant (ON) pour une tension grille-source de 0 V et sa borne de grille (224) étant également reliée, via une seconde connexion (24), à la borne de grille (12) du premier FET (10) ; la seconde connexion (24) fournissant un chemin de courant en parallèle avec la résistance R₁ (220) ; une chute de tension apparaissant au niveau de la résistance R₁ (220) entraînant un blocage croissant du second FET (222), une puissance d'entrée à amplifier Pᵢₙ étant injectée dans le premier FET (10) via une troisième connexion (30) reliée à la borne de grille (12) du premier FET (10).

2. Circuit amplificateur selon la revendication 1, dans lequel une seconde résistance de haute impédance R₂ (240) est disposée dans la seconde connexion (24) pour un découplage HF.

3. Circuit amplificateur selon la revendication 1 ou 2, dans lequel la première connexion (22) et la seconde connexion (24) sont reliées, pour le découplage HF, à la borne de grille du premier FET (10) par une inductance commune L (26).

4. Circuit amplificateur selon l'une quelconque des revendications précédentes, dans lequel le premier FET (10) est un HEMT de puissance HF en GaN ou GaAs.

5. Circuit amplificateur selon l'une quelconque des revendications précédentes, dans lequel le premier FET (10) et le second FET (222) sont intégrés monolithiquement sur une même puce.

6. Circuit amplificateur selon l'une des revendications 1 à 4, dans lequel le premier FET (10) et le second FET (222) sont agencés sur des puces différentes.

7. Circuit amplificateur selon l'une quelconque des revendications précédentes, dans lequel le réseau d'alimentation (20) ne comporte aucune diode ou diode Zener pour limiter le courant de grille au premier FET (10).

8. Dispositif destiné à la réception de signaux micro-ondes, comprenant un circuit amplificateur selon l'une quelconque des revendications précédentes.
